# EUROPÄISCHE PATENTSCHRIFT

(11) **EP 1 082 884 B1**
(45) Veröffentlichungstag und Bekanntmachung des Hinweises auf die Patenterteilung: **16.01.2002**
(21) Anmeldenummer: 99927832.8
(22) Anmeldetag: 01.06.1999
(51) Int. Cl.: H05K 3/34, H01L 21/48

(54) **VERFAHREN ZUR HERSTELLUNG VON VERDRAHTUNGEN MIT LOTHÖCKERN**
METHOD FOR PRODUCING WIRINGS HAVING SOLDER BUMPS
PROCEDE DE REALISATION DE CABLAGES COMPORTANT DES BOSSES DE BRASURE

(30) Priorität: 02.06.1998 DE 19824633
(43) Veröffentlichungstag der Anmeldung: 14.03.2001
(73) Patentinhaber: Siemens S.A., 1060 Bruxelles (BE)
(72) Erfinder: ASCHENBRENNER, Rolf, D-12203 Berlin (DE); KLÖSER, Joachim, D-10823 Berlin (DE); JUNG, Erik, D-14055 Berlin (DE); BOONE, Luc, B-8020 Oostkamp (BE); DE STEUR, Hubert, B-9031 Drongen (BE); HEERMAN, Marcel, B-9200 Merelbeke (BE); VAN PUYMBROECK, Jozef, B-8020 Oostkamp (BE)
(74) Vertreter: Zedlitz, Peter, Dipl.-Inf.
(86) Internationale Anmeldenummer: EP9903802
(87) Internationale Veröffentlichungsnummer: WO9963795

(56) Entgegenhaltungen:
- WO-A-84/02867
- WO-A-93/02831
- WO-A-96/31905
- US-A- 3 778 532
- US-A- 4 926 022
- US-A- 5 282 565

## Beschreibung

Integrierte Schaltkreise bekommen immer höhere Anschlußzahlen und werden dabei immer weiter miniaturisiert. Die bei dieser zunehmenden Miniaturisierung erwarteten Schwierigkeiten mit Lotpastenauftrag und Bestückung sollen durch neue Gehäuseformen behoben werden, wobei hier insbesondere Single-, Few- oder Multi-Chip-Module im Ball Grid Array Package hervorzuheben sind (DE-Z productronic 5, 1994, Seiten 54,55). Diese Module basieren auf einem durchkontaktierten Substrat, auf welchem die Chips beispielsweise über Kontaktierdrähte oder mittels Flipchip-Montage kontaktiert sind. An der Unterseite des Substrats befindet sich das Ball Grid Array (BGA), das häufig auch als Solder Grid Array oder Solder Bump Array bezeichnet wird. Das Ball Grid Array umfaßt auf der Unterseite des Substrats flächig angeordnete Lothöcker, die eine Oberflächenmontage auf den Leiterplatten oder Baugruppen ermöglichen. Durch die flächige Anordnung der Lothöcker können hohe Anschlußzahlen in einem groben Raster von beispielsweise 1,27 mm realisiert werden.

Aus der DE-C-195 35 622 ist ein Verfahren zum Aufbringen von Lothöckern auf flächig verteilte Anschluß-Pads eine Substrats bekannt, bei welchem scheibchenförmige Lotformteile mit einem Vielfach-Sauggreifer in der gewünschten Konfiguration auf den Anschluß-Pads positioniert und danach zu kugelförmigen Lothöckern umgeschmolzen werden.

Aus der WO 93/02831 A ist ein Verfahren zur Herstellung von Verdrahtungen mit Lothöckern bekannt, welches folgende Schritte aufweist:
- Bildung eines Leitermusters auf einem elektrisch isolierenden Substrat, wobei Anschluß-Pads des Leitermusters jeweils mit den zugeordneten weiterführenden Leiterzügen verbunden sind,
- Aufbringen einer Lotschicht auf die Anschluß-Pads und die Leiterzüge,
- Umschmelzen der Lotschicht in einem Bad zur Bildung der Lothöcker auf den Anschluß-Pads.

Bei einer Ausgestaltung des Verfahrens sind die Anschluß-Pads im Kreuzungsbereich von zwei, drei oder vier Leiterzügen vorgesehen. Bei einer anderen Ausgestaltung des Verfahrens weisen die Anschluß-Pads eine größere Breite auf, als die weiterführenden Leiterzüge.

Der im Anspruch 1 angegebenen Erfindung liegt das Problem zugrunde, ein Verfahren zur Herstellung von Verdrahtungen mit Lothöckern zu schaffen, welches eine einfache, schnelle und wirtschaftliche Erzeugung der Lothöcker ermöglicht.

Der Erfindung liegt die Erkenntnis zugrunde, daß auf die Anschluß-Pads eines Leitermusters aufgebrachte Lotschichten praktisch selbsttätig zu Lothöckern umgeschmolzen werden kön-nen, sofern durch in der Breite reduzierte Leiterbereiche ein Abfließen des aufgeschmolzenen Lotes über die anschließenden Leiterzüge verhindert wird. Das auf den in der Breite reduzierten Leiterbereichen aufgeschmolzene Lot fließt dabei zu den Anschluß-Pads hin und vergrößert dementsprechend das Volumen der dort entstehenden Lothöcker. Die für die Bildung der Lothöcker erforderlichen, in der Breite reduzierten Leiterbereiche können bei der Erstellung des Leitermusters der Verdrahtung praktisch ohne zusätzlichen Aufwand realisiert werden.

Vorteilhafte Ausgestaltungen des erfindungsgemäßen Verfahrens gehen aus den Ansprüchen 2 bis 15 hervor.

Die in der Breite reduzierten Leiterbereiche können gemäß den Ansprüchen 2 und 3 auf besonders einfache Weise durch eine Einschnürung der Leiterzüge oder durch in den mittleren Bereich der Leiterzüge eingebrachte Löcher gebildet werden.

Die im Anspruch 4 angegebene Geometrie der Anschluß-Pads und der in der Breite reduzierten Leiterbereiche ermöglicht eine optimale Bildung der Lothöcker durch Umschmelzen der aufgebrachten Lotschicht.

Die Weiterbildung nach Anspruch 5 ermöglicht eine zusätzliche Vergrößerung der Lothöcker, da auch das auf den Lotzufuhrstrukturen aufgeschmolzene Lot zu den Anschluß-Pads hin fließt. Dabei ergeben sich optimale Bedingungen, wenn die im Anspruch 6 angegebene Geometrie der entsprechenden Lotzufuhrstrukturen eingehalten wird.

Gemäß Anspruch 7 sind Lotschichten aus einer Zinn-Blei-Legierung für die Bildung von Lothöckern und auch im Hinblick auf die an die Lothöcker gestellten Anforderungen besonders gut geeignet.

Die Ausgestaltung nach Anspruch 8 ermöglicht eine besonders einfache und sichere Aufbringung der Lotschichten durch galvanische Metallabscheidung. Außerdem kann bei der galvanischen Abscheidung der Lotschichten deren die Größe der Lothöcker bestimmende Stärke leicht überwacht und ggf. auch variiert werden.

Die Weiterbildung nach Anspruch 9 ermöglicht eine einfache kathodische Kontaktierung des Leitermusters bei der galvanischen Abscheidung von Lotschichten.

Die Ausgestaltung nach Anspruch 10 ermöglicht ein selektives Umschmelzen der Lotschichten ohne Erhitzung der gesamten Verdrahtung. Da das Umschmelzen der Lotschichten mit Hilfe eines Laserstrahls außerdem extrem schnell vorgenommen werden kann, ergibt sich eine minimale thermische Belastung der Verdrahtungen.

Die Weiterbildung nach Anspruch 11 ermöglicht eine weitere Reduzierung der thermischen Belastung der Verdrahtung, da hier die Lotschichten nur in den für die Bildung der Lothökker erforderlichen Bereichen selektiv aufgeschmolzen werden. Diese Bereiche umfassen die Anschluß-Pads, die in der Breite reduzierten Leiterbereiche und - sofern vorhanden - gemäß Anspruch 12 auch die Lotzufuhrstrukturen.

Die Weiterbildung nach Anspruch 13 ermöglicht ein sehr rasches Umschmelzen der Lotschichten mit einer besonders geringen thermischen Belastung der Verdrahtung.

Gemäß Anspruch 14 haben sich für das Umschmelzen von Lotschichten zur Bildung von Lothöckern Nd:YAG-Laser mit einer Wellenlänge von 1,06 µm besonders gut bewährt.

Das Laserumschmelzen von Lotschichten kann prinzipiell auch mit einem Diodenlaser-Array oder mit einem streifenförmigen Laserstrahl vorgenommen werden. Gemäß Anspruch 15 wird jedoch das Laserumschmelzen mit Hilfe eines ablenkbaren Laserstrahlsbevorzugt, da sich hierdurch eine sehr hohe Flexibilität ergibt und eine gezielte Auswahl der aufzuschmelzenden Bereiche ermöglicht wird. Außerdem können mit einem ablenkbaren Laserstrahl die aufzuschmelzenden Bereiche einer Lotschicht extrem schnell abgerastert werden.

Ausführungsbeispiele der Erfindung sind in der Zeichnung dargestellt und werden im folgenden näher beschrieben.
Es zeigen:
- Figur 1: bis Figur 6 verschiedene Verfahrensstadien bei der Herstellung einer Verdrahtung und der Bildung von Lothöckern auf den Anschluß-Pads dieser Verdrahtung,
- Figur 7: die fertige Verdrahtung nach dem Auflöten eines Halbleiterbausteins,
- Figur 8: eine Variante mit mehreren zu den Anschluß-Pads hin führenden Lotzufuhrstrukturen und
- Figur 9: eine Variante für die Bildung von in der Breite reduzierten Leiterstrukturen durch in die Leiterzüge mittig eingebrachte Löcher.

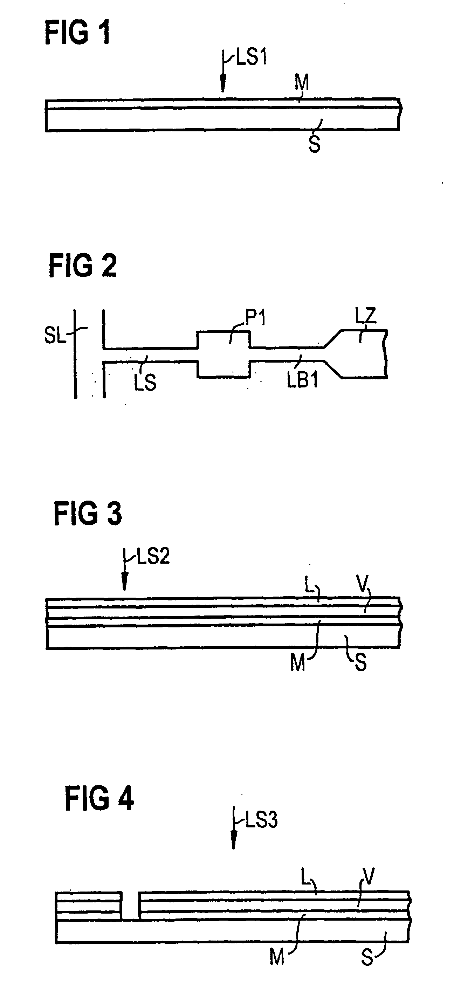

Figur 1 zeigt ein elektrisch isolierendes Substrat S mit einer einseitig aufgebrachten Metallisierung M. Bei dieser Metallisierung M handelt es sich um eine dünne Kupferkaschierung oder um eine durch chemische Abscheidung von Kupfer aufgebrachte Schicht. Die Metallisierung M wird dann mit einem Nd:YAG-Laser mit einer Wellenlänge von 1,06 µm strukturiert, wobei diese Laserstrukturierung in Figur 1 durch einen Laserstrahl LS1 angedeutet ist.

Gemäß Figur 2 entstehen bei der Laserstrukturierung Anschluß-Pads P1 und Leiterzüge LZ, wobei die Anschluß-Pads P1 jeweils über in der Breite reduzierte Leiterbereiche LB1 mit den wei-terführenden Leiterzügen LZ verbunden sind. Die Verdrahtung weist außerdem eine Sammelleitung SL auf, die über in der Breite gegenüber den Leiterzügen LZ ebenfalls reduzierte Lotzufuhrstrukturen LS mit den einzelnen Anschluß-Pads P1 verbunden ist. Die Sammelleitung SL ermöglicht eine kathodische Kontaktierung des gesamten Leitermusters und damit eine galvanische Metallabscheidung auf das Leitermuster.

Gemäß Figur 3 werden auf das Leitermuster nacheinander durch galvanische Metallabscheidung eine Verstärkungsschicht V aus Kupfer und eine Lotschicht L aus einer Zinn-Blei-Legierung aufgebracht. Die elektrische Trennung der Sammelleitung SL vom übrigen Leiterbild wird durch einen in Figur 3 durch einen Pfeil LS2 angedeuteten Laserstrahl eingeleitet. Hierbei wird mit einem Nd:YAG-Laser mit einer Wellenlänge von 0,355 µm oder 1,06 µm die Lotschicht in den unmittelbar an die Sammelleitung SL angrenzenden Bereichen der Lotzufuhrstrukturen LS entfernt, wobei das hierdurch freigelegte Kupfer der Verstärkungsschicht V und der Metallisierung M gemäß Figur 4 durch Ätzen bis zur Oberfläche des Substrats S abgetragen wird.

Figur 4 zeigt ferner einen ablenkbaren Laserstrahl LS3, mit welchem jeweils die Lotschicht L auf einem Anschluß-Pad P1 auf dem davon wegführenden Leiterbereich LB1 und auf der davon wegführenden Lotzufuhrstruktur LS gleichzeitig aufgeschmolzen wird. Hierfür wird ein Nd:YAG-Laser mit einer Wellenlänge von 1,06 µm verwendet, dessen Laserstrahl LS3 stark außer Fokus gestellt ist.

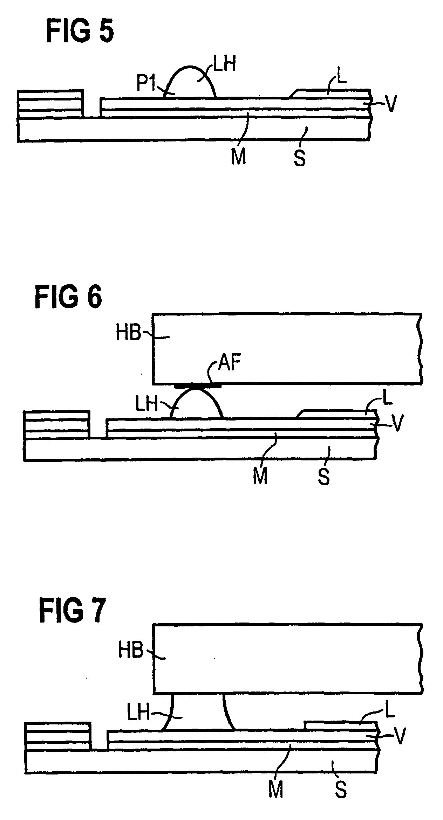

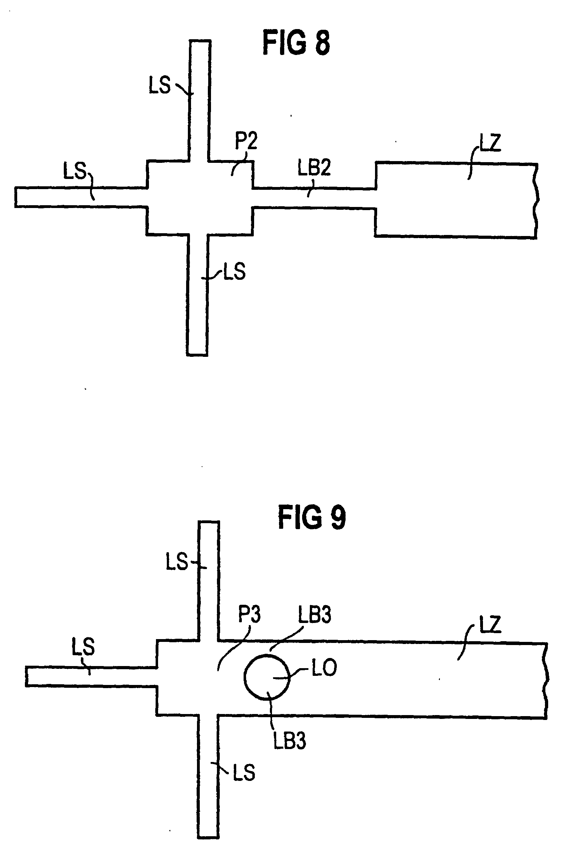

Bei dem geschilderten Laserumschmelzen der Lotschicht L fließt das flüssige Lot von der schmalen Lotzufuhrstruktur L S und von dem schmalen Leiterbereich LB1 zum Anschluß-Pad P1 hin, so daß dort gemäß Figur 5 von selbst ein Lothöcker LH entsteht. Das Volumen des Lothöckers LH kann ggf. durch anhand der Figuren 8 und 9 noch zu erläuternde Maßnahmen weitervergrößert werden.

Figur 6 zeigt die Anordnung eines höckerlosen Halbleiterbauseins HB auf der Verdrahtung, dessen beispielsweise aus einer Schichtenfolge von Aluminium, Nickel und Gold bestehenden Anschlußflächen AF unmittelbar auf den Kuppen der zugeordneten Lothöcker LH aufliegen. Werden anschließend alle dem Halbleiterbausein HB zugeordneten Lothöcker LH beispielsweise durch Reflow-Löten oder durch Laserlöten gleichzeitig aufgeschmolzen, so ergeben sich zuverlässige Lötverbindungen mit der aus Figur 7 ersichtlichen konkaven Form der Lothöcker LH.

Figur 8 zeigt ein hier mit P2 bezeichnetes Anschluß-Pad, welches über einen eingeschnürten Leiterbereich LB2 mit dem weiterführenden Leiterzug LZ verbunden ist. Außerdem führen zu dem Anschluß-Pad P2 insgesamt drei blind endende Lotzufuhrstrukten LS hin, die eine entsprechende Vergrößerung des Lotvolumens des auf dem Anschluß-Pad P2 entstehenden Lothöckers bewirken.

## Patentansprüche

1. Verfahren zur Herstellung von Verdrahtungen mit Lothöckern (LH) für die Flipchip-Montage oder die Oberflächenmontage, mit folgenden Schritten:
- Bildung eines Leitermusters auf einem elektrisch isolierenden Substrat (S), wobei Anschluß-Pads (P1; P2; P3) des Leitermusters jeweils über in der Breite gegenüber der Breite der Leiterzüge (LZ) reduzierte Leiterbereiche (LB1; LB2; LB3) mit den zugeordneten weiterführenden Leiterzügen (LZ) verbunden sind,
- Aufbringen einer Lotschicht (L) auf das Leitermuster, zumindest im Bereich der Anschluß-Pads (P1; P2, P3) und der in der Breite reduzierten Leiterbereiche (LB1; LB2; LB3),
- Umschmelzen der Lotschicht (L) zur Bildung der Lothöcker (LH) auf den Anschluß-Pads (P1; P2; P3).

2. Verfahren nach Anspruch 1, **dadurch gekennzeichnet, daß** die in der Breite reduzierten Leiterbereiche (LB1; LB2) durch eine Einschnürung der Leiterzüge (LZ) gebildet werden.

3. Verfahren nach Anspruch 1, **dadurch gekennzeichnet, daß** die in der Breite reduzierten Leiterbereiche (LB3) durch das Einbringen eines Loches (LO) in den mittleren Bereich der Leiterzüge (LZ) gebildet werden.

4. Verfahren nach einem der vorhergehenden Ansprüche, **dadurch gekennzeichnet, daß** Anschluß-Pads (P1; P2; P3) mit Flächenabmessungen zwischen 100x100 µm² und 250x250 µm² gebildet werden und daß in der Breite reduzierte Leiterbereiche (LB 1; LB2; LB3) mit einer Breite zwischen 10 µm und 40 µm und einer Länge zwischen 100 µm und 500 µm gebildet werden.

5. Verfahren nach einem der vorhergehenden Ansprüche, **dadurch gekennzeichnet, daß** bei der Bildung des Leitermusters zusätzliche Lotzufuhrstrukturen (LS) erzeugt werden, wobei von den einzelnen Anschluß-Pads (P1; P2; P3) jeweils mindestens eine, in der Breite gegenüber der Breite der Leiterzüge (LZ) reduzierte Lotzufuhrstruktur (LS) wegführt.

6. Verfahren nach Anspruch 5, **dadurch gekennzeichnet, daß** Lotzufuhrstrukturen (LS) mit einer Breite zwischen 10 µm und 40 µm und einer Länge zwischen 100 µm und 500 µm gebildet werden.

7. Verfahren nach einem der vorhergehenden Ansprüche, **dadurch gekennzeichnet, daß** auf das Leitermuster eine aus einer Zinn-Blei-Legierung bestehende Lotschicht (L) aufgebracht wird.

8. Verfahren nach einem der vorhergehenden Ansprüche, **dadurch gekennzeichnet, daß** die Lotschicht (L) durch galvanische Metallabscheidung auf das Leitermuster aufgebracht wird.

9. Verfahren nach Anspruch 8, **dadurch gekennzeichnet, daß** die kathodische Kontaktierung des Leitermusters bei der galvanischen Metallabscheidung über eine mit sämtlichen Anschluß-Pads (P1; P2; P3) verbundene Sammelleitung (SL) vorgenommen wird und daß die Sammelleitung (SL) nach der Metallabscheidung abgetrennt wird.

10. Verfahren nach einem der vorhergehenden Ansprüche, **dadurch gekennzeichnet, daß** die Lotschicht (L) mit Hilfe eines Laserstrahls (LS3) umgeschmolzen wird.

11. Verfahren nach Anspruch 10, **dadurch gekennzeichnet, daß** die Lotschichten (L) jeweils selektiv im Bereich der Anschluß-Pads (P1; P2; P3) und der davon wegführenden, in der Breite reduzierten Leiterbereiche (LB1; LB2; LB3) umgeschmolzen werden.

12. Verfahren nach den Ansprüchen 5 und 11, **dadurch gekennzeichnet, daß** die Lotschichten (L) jeweils selektiv im Bereich der Anschluß-Pads (P1; P2; P3), der davon wegführenden, in der Breite reduzierten Leiterbereiche (LB1; LB2; LB3) und der davon wegführenden Lotzufuhrstrukturen (LS) umgeschmolzen werden.

13. Verfahren nach einem der Ansprüche 10 bis 12, **dadurch gekennzeichnet, daß** die Lotschichten (L) mit Hilfe eines stark außer Fokus gestellten Laserstrahls (LS3) umgeschmolzen werden.

14. Verfahren nach einem der Ansprüche 10 bis 13, **dadurch gekennzeichnet, daß** die Lotschichten (L) mit dem Laserstrahl (LS3) eines Nd:YAG-Lasers mit einer Wellenlänge von 1,06 µm umgeschmolzen werden.

15. Verfahren nach einem der Ansprüche 10 bis 14, **dadurch gekennzeichnet, daß** die Lotschichten (L) mit Hilfe eines ablenkbaren Laserstrahls (LS3) umgeschmolzen werden.

## Claims

1. Method for producing wiring arrangements having solder bumps (LH) for flip-chip mounting or surface mounting, having the following steps:
- formation of a conductor pattern on an electrically insulating substrate (S), connection pads (P1; P2; P3) of the conductor pattern each being connected to the assigned conductor tracks (LZ), which extend further, via conductor regions (LB1; LB2; LB3) of reduced width compared with the width of the conductor tracks (LZ),
- application of a solder layer (L) to the conductor pattern, at least in the region of the connection pads (P1; P2, P3) and of the conductor regions (LB1; LB2; LB3) of reduced width,
- remelting of the solder layer (L) to form the solder bumps (LH) on the connection pads (P1; P2; P3).

2. Method according to Claim 1, **characterized in that** the conductor regions (LB1; LB2) of reduced width are formed by a constriction of the conductor tracks (LZ).

3. Method according to Claim 1, **characterized in that** the conductor regions (LB3) of reduced width are formed by introducing a hole (LO) in the central region of the conductor tracks (LZ).

4. Method according to one of the preceding claims, **characterized in that** connection pads (P1; P2; P3) having area dimensions of between 100×100 µm² and 250×250 µm² are formed, and **in that** conductor regions (LB 1; LB2; LB3) of reduced width are formed with a width of between 10 µm and 40 µm and a length of between 100 µm and 500 µm.

5. Method according to one of the preceding claims, **characterized in that** additional solder supply structures (LS) are produced during the formation of the conductor pattern, at least one solder supply structure (LS), which has a reduced width compared with the width of the conductor tracks (LZ), leading away from each of the individual connection pads (P1; P2; P3).

6. Method according to Claim 5, **characterized in that** solder supply structures (LS) are formed with a width of between 10 µm and 40 µm and a length of between 100 µm and 500 µm.

7. Method according to one of the preceding claims, **characterized in that** a solder layer (L) composed of a tin-lead alloy is applied to the conductor pattern.

8. Method according to one of the preceding claims, **characterized in that** the solder layer (L) is applied to the conductor pattern by electrodeposition of metal.

9. Method according to Claim 8, **characterized in that** cathodic contact is made with the conductor pattern during the electrodeposition of metal via a collective line (SL) connected to all of the connection pads (P1; P2; P3), and **in that** the collective line (SL) is separated after the deposition of metal.

10. Method according to one of the preceding claims, **characterized in that** the solder layer (L) is remelted with the aid of a laser beam (LS3).

11. Method according to Claim 10, **characterized in that** the solder layers (L) are each remelted selectively in the region of the connection pads (P1; P2; P3) and of the conductor regions (LB1; LB2; LB3) of reduced width which lead away therefrom.

12. Method according to Claims 5 and 11, **characterized in that** the solder layers (L) are each remelted selectively in the region of the connection pads (P1; P2; P3), of the conductor regions (LB1; LB2; LB3) of reduced width which lead away therefrom, and of the solder supply structures (LS) which lead away therefrom.

13. Method according to one of Claims 10 to 12, **characterized in that** the solder layers (L) are remelted with the aid of a greatly defocused laser beam (LS3).

14. Method according to one of Claims 10 to 13, **characterized in that** the solder layers (L) are remelted with the laser beam (LS3) of an Nd:YAG laser having a wavelength of 1.06 µm.

15. Method according to one of Claims 10 to 14, **characterized in that** the solder layers (L) are remelted with the aid of a deflectable laser beam (LS3).

## Revendications

1. Procédé de réalisation de câblages comportant des bosses de brasure (LH) pour le montage de flip chips ou le montage en surface, comportant les étapes suivantes :
- réalisation d'un modèle de conducteur sur un substrat (S) isolant électriquement, les pattes de connexion (P1 ; P2 ; P3) du modèle de conducteur étant reliées, à chaque fois par des zones conductrices (LB1 ; LB2; LB3) réduites en largeur par rapport à la largeur des fils conducteurs (LZ) suivants, auxdits fils conducteurs (LZ) suivants associés,
- dépôt d'une couche de brasure (L) sur le modèle de conducteur, au moins au niveau des pattes de connexion (P1 ; P2 ; P3) et des zones conductrices (LB1 ; LB2 ; LB3) réduites en largeur,
- refusion de la couche de brasure (L) en vue de la réalisation des bosses de brasure (LH) sur les pattes de connexion (P1 ; P2 ; P3).

2. Procédé selon la revendication 1, **caractérisé en ce qu'**on réalise les zones conductrices (LB1 ; LB2) réduites en largeur par une contraction des fils conducteurs (LZ).

3. Procédé selon la revendication 1, **caractérisé en ce qu'**on réalise les zones conductrices (LB3) réduites en largeur en ménageant un trou (LO) dans la partie centrale des fils conducteurs (LZ).

4. Procédé selon l'une des revendications précédentes, **caractérisé en ce qu'**on réalise des pattes de connexion (P1 ; P2 ; P3) avec des dimensions de la surface comprises entre 100x100 µm² et 250x250 µm² et **en ce qu'**on réalise des zones conductrices (LB1 ; LB2 ; LB3) réduites en largeur avec une largeur comprise entre 10 µm et 40 µm et une longueur comprise entre 100 µm et 500 µm.

5. Procédé selon l'une des revendications précédentes, **caractérisé en ce que** lors de la réalisation du modèle de conducteur, on crée des structures d'apport de brasure (LS) supplémentaires, au moins une structure d'apport de brasure (LS) réduite en largeur par rapport à la largeur des fils conducteurs (LZ) partant à chaque fois des différentes pattes de connexion (P1 ; P2 ; P3).

6. Procédé selon la revendication 5, **caractérisé en ce qu'**on réalise les structures d'apport de brasure (LS) avec une largeur comprise entre 10 µm et 40 µm et une longueur comprise entre 100 µm et 500 µm.

7. Procédé selon l'une des revendications précédentes, **caractérisé en ce qu'**on dépose sur le modèle de conducteur une couche de brasure (L) composée d'un alliage à base d'étain et de plomb.

8. Procédé selon l'une des revendications précédentes, **caractérisé en ce qu'**on dépose la couche de brasure (L) par dépôt électrolytique de métal sur le modèle de conducteur.

9. Procédé selon la revendication 8, **caractérisé en ce qu'**on établit le contact cathodique du modèle de conducteur, lors du dépôt électrolytique de métal, à l'aide d'une ligne collectrice (SL) reliée à l'ensemble des pattes de connexion (P1 ; P2 ; P3) et **en ce qu'**on coupe la ligne collectrice (SL) après le dépôt de métal.

10. Procédé selon l'une des revendications précédentes, **caractérisé en ce qu'**on refond la couche de brasure (L) à l'aide d'un rayon laser (LS3).

11. Procédé selon la revendication 10, **caractérisé en ce qu'**on refond les couches de brasure (L), à chaque fois sélectivement, au niveau des pattes de connexion (P1 ; P2 ; P3) et des zones conductrices (LB1 ; LB2 ; LB3) réduites en largeur partant de ces dernières.

12. Procédé selon les revendications 5 et 11, **caractérisé en ce qu'**on refond les couches de brasure (L), à chaque fois sélectivement, au niveau des pattes de connexion (P1 ; P2 ; P3), des zones conductrices (LB1 ; LB2 ; LB3) réduites en largeur partant de ces dernières et des structures d'apport de brasure (LS) partant de ces dernières.

13. Procédé selon l'une des revendications 10 à 12, **caractérisé en ce qu'**on refond les couches de brasure (L) à l'aide d'un rayon laser (LS3) fortement défocalisé.

14. Procédé selon l'une des revendications 10 à 13, **caractérisé en ce qu'**on refond les couches de brasure (L) au rayon laser (LS3) d'un laser Nd-Y.A.G ayant une longueur d'onde de 1,06 µm.

15. Procédé selon l'une des revendications 10 à 14, **caractérisé en ce qu'**on refond les couches de brasure (L) à l'aide d'un rayon laser (LS3) pouvant être défléchi.
